# EUROPÄISCHE PATENTSCHRIFT

(11) **EP 4 483 131 B1**
(45) Veröffentlichungstag und Bekanntmachung des Hinweises auf die Patenterteilung: **14.01.2026**
(21) Anmeldenummer: 23702257.9
(22) Anmeldetag: 25.01.2023
(51) Int. Cl.: G01B 9/02091

(54) **VORRICHTUNG UND VERFAHREN ZUM VERMESSEN VON WAFERN**
DEVICE AND METHOD FOR MEASURING WAFERS
DISPOSITIF ET PROCÉDÉ DE MESURE DE PLAQUETTES

(30) Priorität: 24.02.2022 DE 102022104416
(43) Veröffentlichungstag der Anmeldung: 01.01.2025
(73) Patentinhaber: Precitec Optronik GmbH, 63263 Neu-Isenburg (DE)
(72) Erfinder: WEISS, Stephan, 63110 Rodgau (DE); MIETH, Simon, 60599 Frankfurt am Main (DE); WEIGELT, Corinna, 63225 Langen (DE); BECK, Tobias, 63150 Heusenstamm (DE)
(74) Vertreter: Ostertag & Partner Patentanwälte mbB
(86) Internationale Anmeldenummer: PCT/EP2023/051737
(87) Internationale Veröffentlichungsnummer: WO 2023/160929

(56) Entgegenhaltungen:
- US-A1- 2012 232 686
- US-A1- 2016 039 045
- US-A1- 2019 310 463

## Beschreibung

### HINTERGRUND DER ERFINDUNG

### 1. Gebiet der Erfindung

Die Erfindung betrifft eine Vorrichtung und ein Verfahren zum berührungslosen Messen geometrischer Größen von Wafern wie TTV, Verbiegung oder Verwölbung, gemäß dem Oberbegriff des Anspruchs 1 bzw. des Anspruchs 12. Eine solche Vorrichtung und ein solches Verfahren sind aus der US 2019/0310463 A1 bekannt.

### 2. Beschreibung des Standes der Technik

Als Wafer werden kreisrunde oder quadratische und rund ein Millimeter dicke Scheiben bezeichnet, die als Substrat für integrierte Schaltkreise, mikromechanische Bauelemente oder photoelektrische Beschichtungen dienen. Wafer werden aus ein- oder polykristallinen Rohlingen (sog. Ingots) hergestellt, die quer zu ihrer Längsachse in die einzelnen Wafer zersägt werden. In den meisten Fällen werden Wafer aus Silizium verwendet, es kommen aber auch andere Materialien zum Einsatz, z.B. Glaswafer zur Herstellung von Mikrolinsen-Arrays oder für Augmented-Reality-Anwendungen.

Die Form der Wafer muss engen geometrischen Spezifikationen entsprechen. Zu diesen Spezifikationen gehört die TTV (engl. für *Total Thickness Variation),* worunter man die maximale Differenz zwischen der dicksten und dünnsten Stelle eines Wafers versteht. Die Verbiegung (engl. *Bow*) ist als maximale Abweichung der Median-Fläche des Wafers von einer Referenzebene definiert. Unter der Verwölbung (engl. *Warp*) versteht der Fachmann die Abweichung der Median-Fläche des Wafers von der Referenzebene, bei der die Verbiegung über die gesamte Waferfläche bereits korrigiert ist.

Neben diesen gängigen Definitionen von TTV, Verbiegung und Verwölbung werden bei der Charakterisierung von Wafern bisweilen auch ähnliche, leicht unterschiedliche Definitionen verwendet, um Abweichung des Wafers von der Idealform zu charakterisieren.

Um die Spezifikationen einhalten zu können, müssen diese geometrischen Größen zumindest stichprobenartig und vorzugsweise im regulären Produktionsablauf gemessen werden.

Aus der US 2012/0257207 A1 ist eine Vorrichtung zum Vermessen von Wafern bekannt, das ein Michelson-Interferometer für Abstandsmessungen mit einem Reflektometer kombiniert, das für Dickenmessungen verwendet wird. Die Messung erfolgt dabei an einzelnen Punkten. Um über die gesamte Oberfläche hinweg Messwerte zu erhalten, wird der Wafer relativ zur stationären Messvorrichtung bewegt.

Dieses bekannte Messverfahren ist allerdings langsam, da der Wafer aufgrund seiner Massenträgheit nicht beliebig schnell bewegt werden kann. Die entsprechenden Messvorrichtungen sind zudem teuer, da die Aktorik für die Verfahrbewegungen des Wafers besonders hochwertig sein muss, damit die Bewegungen ruckfrei und präzise sind.

Aus der US 2019/0310463 A1 ist eine Ablenkeinheit zur Laserfertigung und zum Beobachten eines Laserfertigungsprozesses bekannt. Die Ablenkeinheit umfasst eine XY-Ablenkvorrichtung, um den ausgetretenen Arbeitsstrahl zu scannen, und eine Fokussiervorrichtung zur Fokussierung des Arbeitsstrahls, wobei die Fokussiervorrichtung eine veränderbare Brennweite aufweist.

Aus der US 2012/0232686 A1 ist ein System zur Ausrichtung von zwei Wafern offenbart, das einen optischen Kohärenztomographen und ein Ausrichtungssystem umfasst, mit dem sich die relative Position zweier Wafers einstellen lässt. Der optische Kohärenztomograph berechnet Koordinatendaten für eine Vielzahl von Ausrichtungsmarkierungen auf den beiden Wafern und übermittelt diese Koordinatendaten an das Ausrichtungssystem.

Aufgabe der Erfindung ist es, eine Vorrichtung und ein Verfahren anzugeben, mit dem sich Wafer sehr schnell und trotzdem kostengünstig vermessen lassen.

### ZUSAMMENFASSUNG DER ERFINDUNG

Hinsichtlich der Vorrichtung wird diese Aufgabe gelöst durch eine Vorrichtung mit den Merkmalen des Anspruchs 1.

Die Erfindung beruht auf der Erkenntnis, dass man eine an sich bekanntes Messvorrichtung mit einem optischen Kohärenztomographen und einer Scaneinrichtung für die Wafervermessung einsetzen kann, wenn man zum einen ein größeres optisches System einsetzt, das ein größeres Messfeld ermöglicht, und vor allem das Problem der Feldkrümmung löst. Die Erfinder haben mehrere Lösungsansätze für dieses Problem entwickelt.

Eine solche an sich bekannte Messvorrichtung ist aus der DE 10 2017 128 158 A1 bekannt. Bei einem dort beschriebenen Ausführungsbeispiel erzeugt ein optischer Kohärenztomograph (OCT, engl. für *Optical Coherence Tomography*) einen Messlichtstrahl, der von einem Spiegelscanner abgelenkt wird, wobei pro Ablenkrichtung ein Scanspiegel vorgesehen ist. Nach Durchtritt durch ein Planfeldobjektiv trifft der Messlichtstrahl im Wesentlichen achsparallel auf die zu messende Oberfläche auf, was zu einem telezentrischen Strahlengang führt. Beim Abtasten der Oberfläche bewegt sich nur der sehr leichte Scanspiegel, während das Messobjekt ruht. Dadurch kann dessen Oberfläche sehr schnell abgetastet werden.

Ein weiterer Vorteil einer solchen Messvorrichtung liegt darin, dass die Auslenkung der Spiegel in Echtzeit ausgelesen und durch eine Regelschleife an die Soll-Auslenkung angepasst werden kann. Selbst wenn die Scan-Spiegel aufgrund ihrer Bewegung parasitären Rest-Schwingungen unterworfen sind, kann damit eine sehr genaue Positionierung des Messlichtstrahls auf dem Messobjekt erreicht werden.

Die Erfinder haben festgestellt, dass es mit dieser bekannten Messvorrichtung zu einer Feldkrümmung kommt, wenn der Messlichtstrahl zweidimensional die Oberfläche eines Wafers abtastet. Anschaulich gesprochen bedeutet dies, dass der Fokus des Messlichtstrahls beim Scannen nicht eine Ebene überstreicht, sondern eine gekrümmte Fläche. Eine eigentlich plane Waferoberfläche erscheint daher gekrümmt.

Während bei sehr kleinen Wafern bis zu etwa 80 mm Durchmessern die Feldkrümmung noch toleriert werden könnte, ist dies bei größeren Wafern nicht möglich, da die Feldkrümmung quadratisch mit dem Durchmesser des zu vermessenden Wafers wächst. Als größere Wafer werden vorliegend solche Wafer angesehen, bei denen zwei von der Scaneinrichtung errechbare Messpunkte einen Abstand dₘₐₓ mit 140 mm ≤ dₘₐₓ≤ 600 mm und vorzugsweise mit 280 mm ≤ dₘₐₓ≤ 450 mm haben können. Für einen Abstand dₘₐₓ = 300 mm beträgt der Messfehler infolge der Feldkrümmung typischerweise bereits rund 1 mm. Ohne zusätzliche Maßnahmen ist die vorstehend beschriebene Messvorrichtung somit selbst dann, wenn man ein größeres Planfeldobjektiv einsetzt, für die Vermessung von größeren Wafern ungeeignet, da die erforderliche Genauigkeit bei der Abstandsmessung bei weniger als 1 µm liegt. Der Messfehler der bekannten Messvorrichtung ist somit bei größeren Wafern um drei Größenordnungen zu groß.

Es wurde von den Erfindern ferner erkannt, dass die hinzutretenden optischen Weglängenunterschiede, die zu der Feldkrümmung führen, vor allem von den Scanspiegeln verursacht werden. Um kollisionsfrei verschwenken zu können, müssen die beiden Scanspiegel relativ weit voneinander beabstandet sein. Es hat sich herausgestellt, dass der räumliche Abstand der Drehachsen der Scanspiegel den dominierenden Beitrag zur Feldkrümmung liefert.

Die einfachste Maßnahme, die Feldkrümmung zu verringern, besteht deswegen darin, anstelle von zwei Scanspiegeln, die jeweils um genau eine Achse drehbar gelagert sind, einen einzigen Scanspiegel einzusetzen, der um zwei Achsen drehbar gelagert ist. Allerdings lassen sich die derzeit verfügbaren zweiachsigen Scanspiegel nicht so schnell und genau verschwenken wie zwei einachsige Scanspiegel. Gegenüber dem bekannten Verfahren, bei denen der Wafer bewegt werden muss, ergibt sich dennoch eine deutliche Verkürzung der benötigten Messzeit.

Ein anderer Ansatz zur Verringerung der Feldkrümmung besteht darin, zwar wie bisher zwei Scanspiegel zu verwenden, die jeweils um genau eine Achse drehbar gelagert sind, den Abstand zwischen den Scanspiegeln aber deutlich zu verkürzen. Dann besteht allerding die Gefahr, dass die Scanspiegel bei größeren Drehwinkeln kollidieren. Um dies auszuschließen, kann mindestens einem der zwei Scanspiegel eine Kollisionsschutzeinrichtung zugeordnet sein, die dazu eingerichtet ist, die Drehwinkel des mindestens einen Scanspiegels zu begrenzen. Dahinter steht die Überlegung, dass die verfügbaren Scanspiegel üblicherweise von Hause aus einen Drehwinkelbereich haben, der für die vorliegende Anwendung nur teilweise benötigt wird. Wenn die Kollisionsschutzeinrichtung die zunächst möglichen Drehwinkel (typischerweise ±20°) auf die tatsächlich benötigten Drehwinkel (z.B. ± 10° und vorzugsweise ± 5°) begrenzt, können Kollisionen der Scanspiegel auch bei sehr kleinem Abstand zwischen den Scanspiegeln zuverlässig ausgeschlossen werden.

Die Kollisionsschutzeinrichtung kann mindestens einen mechanischen Anschlag aufweisen, um die Drehwinkel zu begrenzen. Dieser Anschlag kann z.B. ein Dämpfer aus Gummi sein, auf den der mindestens eine Scanspiegel trifft, wenn er stärker als z.B. ± 10° oder ± 5° ausgelenkt wird. Alternativ kann der Anschlag direkt auf die Drehachse des mindestens einen Scanspiegels oder einen an der Drehachse ausgebildeten Vorsprung einwirken.

Alternativ oder zusätzlich kommt in Betracht, die Kollisionseinrichtung als eine elektronische Begrenzungseinrichtung auszuführen, die dazu eingerichtet ist, elektronisch eine Zufuhr von Steuersignalen an den mindestens einen Scanspiegel zu verhindern, die zu einem Überschreiten eines vorgegebenen Drehwinkelbereichs führen würde. Sehr zuverlässig sind beispielsweise Drosselspulen, um den Steuerstrom für die Scanspiegel zu begrenzen.

Alternativ oder zusätzlich kann die Ansteuerungssoftware der Scanspiegel so beschaffen sein, dass sie die Erzeugung von Steuerungssignalen verhindert, die eine zu starke Auslenkung der Scanspiegel bewirken würden. Die zusätzliche Verwendung einer der oben genannten Maßnahmen ist auch in diesem Fall zur Absicherung sinnvoll, um für den Fall vorzusorgen, dass es zu einer Fehlfunktion der Software kommt und ein fehlerhaftes Signal erzeugt wird, das eine zu starke Auslenkung eines der beiden Scanspiegeln bewirken würde.

Eine weitere alternative oder zusätzliche Maßnahme zur Verringerung der Feldkrümmung sieht vor, ein optisches System einzusetzen, das zur Korrektur der Feldkrümmung mindestens ein und vorzugsweise zwei anamorphotische optische Elemente enthält. Vorzugsweise handelt es sich bei den anamorphotischen Elementen um Zylinderlinsen. Deren Symmetrieachsen sind bezüglich ihrer Orientierung an die Orientierung der Drehachsen der Scanspiegel angepasst.

Die bevorzugte erfindungsgemäße Maßnahme besteht darin, die Feldkrümmung nicht zu verringern, sondern ihre Auswirkungen im Wege einer Kalibrierung zu eliminieren. Dazu sollte die Auswerteeinheit dazu eingerichtet sein, die gemessenen Abstandswerte rechnerisch zu korrigieren, um eine Krümmung des Feldes zu kompensieren, in welches das optische System die Messlichtstrahlen fokussiert. Üblicherweise fällt dieses Feld mit der Brennebene des optischen Systems zusammen. Bei der Kalibrierung wird z.B. ein hochgenau gefertigtes Planglas vermessen. Die gemessenen Abweichungen von der Planarität stellen Korrekturwerte dar, die bei späteren Messungen von den gemessenen Werten je nach Vorzeichen subtrahiert oder addiert werden.

Zur rechnerischen Korrektur können die Korrekturwerte aus einer in der Auswerteeinheit gespeicherten Korrekturtabelle ausgelesen werden. Vorzugsweise sind in der Korrekturtabelle Korrekturwerte für unterschiedliche Betriebswellenlängenbereiche gespeichert. Diese Korrekturwerte für unterschiedliche Betriebswellenlängenbereiche müssen nicht durch eigene Kalibriermessungen ermittelt werden, sondern können auch aufgrund theoretischer Überlegungen aus Korrekturwerten abgeleitet werden, die für einen bestimmten Betriebswellenlängenbereich ermittelt wurden. Dabei können insbesondere auch Zernike-Polynome zur Anwendung kommen.

Alternativ zum Auslesen aus einer Korrekturtabelle können die Korrekturwerte auch aus einer mathematischen Formel berechnet werden. Diese Formel lässt sich z.B. aus einem Polynomfit ableiten. Als Polynome können dabei beispielsweise Zernike-Polynome verwendet werden.

Selbstverständlich kann eine Kalibrierung auch zusätzlich zu den weiter oben erläuterten Maßnahmen durchgeführt werden.

Ein für die Erfindung einsetzbarer optischer Kohärenztomograph kann insbesondere aufweisen:
eine Lichtquelle,
einen Strahlteiler, der dazu eingerichtet ist, von der Lichtquelle erzeugtes Licht in den Messlichtstrahl und einen Referenzlichtstrahl aufzuteilen,
einen Referenzarm zur Führung des Referenzlichtstrahls,
einen das optische System und die Scaneinrichtung nutzenden Objektarm zur Führung des Messlichtstrahls, und
einen Detektor, der dazu eingerichtet ist, aus einer Überlagerung des im Referenzarm geführten Referenzlichtstrahls mit einem an dem Wafer reflektierten Anteil des Messlichtstrahls die Interferenzsignale zu erzeugen.

Bei einem Ausführungsbeispiel ist im Referenzarm eine schaltbare Abblendeinrichtung angeordnet, die dazu eingerichtet ist, bei der Vornahme von Dickenmessungen die Ausbreitung des Referenzlichts im Referenzarm zu unterbinden. Die schaltbare Abblendeinrichtung ermöglicht es, zwischen einem "Abstandsmodus", bei dem die Interferenz zwischen dem Messlichtstrahl und dem Referenzlichtstrahl ausgewertet wird, und zwischen einem "Dickenmodus" zu wechseln. Beim Dickenmodus wird aus der Interferenz zwischen den Reflektionen des Messlichtstrahls an den zwei planparallelen Grenzflächen des Wafers auf den Abstand der Grenzflächen (d.h. die Dicke des Wafers) zurückgeschlossen. Der Detektor erzeugt somit die Interferenzsignale aus einer Überlagerung von an zwei unterschiedlichen Grenzflächen des Wafers reflektierten Anteilen des Messlichtstrahls. Damit im Dickenmodus nicht der nicht benötigte Referenzlichtstrahls aus dem Referenzarm das gewünschte Interferenzsignal störend überlagert, wird die Ausbreitung des Referenzlichtstrahls im Referenzarm mit der Abblendeinrichtung unterbunden. Die Umschaltung der Abblendeinrichtung erfolgt vorzugsweise automatisch bei jedem Wechsel des Messmodus.

Bei einem anderen Ausführungsbeispiel wird der Referenzlichtstrahl im Referenzarm nicht oder jedenfalls nicht durchweg als Freistrahl geführt, sondern zumindest teilweise in einer optischen Faser. In aufgerollten optischen Fasern lässt sich Licht über große optische Weglängen hinweg auf kleinem Raum führen. Falls der Objektarm und der Referenzarm unterschiedliche Dispersionen haben, sind Maßnahmen zum Dispersionsausgleich zweckmäßig.

Hinsichtlich des Verfahrens wird die eingangs gestellte Aufgabe gelöst durch ein Verfahren mit den Merkmalen des Anspruchs 12.

Bei der Vornahme von Dickenmessungen kann im Referenzarm die Ausbreitung des Referenzlichtstrahls durch eine Abblendeinrichtung zeitweilig unterbunden werden.

Wenn das optische System ein Feld hat, in das die Messlichtstrahlen fokussiert werden, können die gemessenen Abstandswerte rechnerisch korrigiert werden, um eine Krümmung des Feldes zu kompensieren. Zur rechnerischen Korrektur können Korrekturwerte aus einer in der Auswerteeinheit gespeicherten Korrekturtabelle ausgelesen werden. In der Korrekturtabelle können dabei Korrekturwerte für unterschiedliche Betriebswellenlängen gespeichert sein.

### KURZE BESCHREIBUNG DER ZEICHNUNGEN

Nachfolgend werden Ausführungsbeispiele der Erfindung anhand der Zeichnungen näher erläutert. In diesen zeigen:
- Figur 1: einen zu vermessenden Wafer in einer perspektivischen und nicht maßstäblichen Darstellung;
- Figur 2: eine erfindungsgemäße Messvorrichtung in einer schematischen Darstellung;
- Figur 3: wichtige Teile einer Scaneinrichtung, die Teil einer Messvorrichtung gemäß einem anderen Ausführungsbeispiel ist und mechanische Anschläge für die Scanspiegel enthält, in einer vereinfachten perspektivischen Darstellung;
- Figur 4: wichtige Teile einer Scaneinrichtung, die Teil einer Messvorrichtung gemäß einem weiteren Ausführungsbeispiel ist und nur einen einzigen Scanspiegel enthält, in einer vereinfachten perspektivischen Darstellung;
- Figuren 5a und 5b: ein optisches System mit Zylinderlinsen, das Teil einer Messvorrichtung gemäß einem weiteren Ausführungsbeispiels ist, in zwei orthogonalen meridionalen Schnitten;
- Figur 6: einen Referenzarm eines optischen Kohärenztomographen gemäß einem Ausführungsbeispiel, bei dem der Referenzlichtstrahl ein Teil des optischen Weges in einer optischen Faser zurücklegt.

### BESCHREIBUNG BEVORZUGTER AUSFÜHRUNGSBEISPIELE

### 1. Vermessung von Wafern

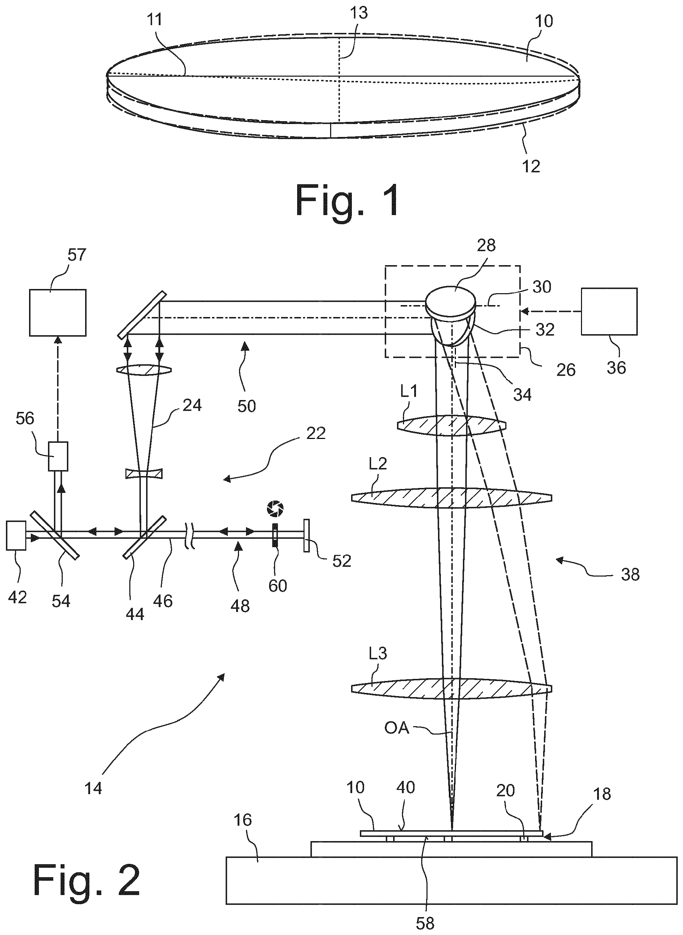

Die Figur 1 zeigt einen Wafer 10 in einer perspektivischen, aber nicht maßgeblichen Darstellung. Der Wafer 10 hat im dargestellten Ausführungsbeispiel die Form eines geraden Kreiszylinders, wobei die Dicke deutlich übertrieben dargestellt ist. Reale Wafer 10 haben beispielsweise einen Durchmesser von 300 mm, während die Dicke lediglich rund 1 mm beträgt. Gelegentlich werden auch Wafer 10 verwendet, deren Oberfläche nicht kreisrund, sondern quadratisch ist.

Mit gestrichelten Linien 12 ist die ideale kreiszylindrische Form des Wafers 10 angedeutet. Aufgrund von Fertigungstoleranzen kann es zu Abweichungen von dieser idealen Form kommen, die in der Figur 1 übertrieben dargestellt sind. Um diese Abweichungen zu bestimmen, muss der Wafer 10 vermessen werden. Wenn die Topografie beider Waferoberflächen vermessen wird, lassen sich daraus alle gängigen geometrischen Spezifikation des Wafers wie TTV, Verbiegung und Verwölbung ableiten.

Die Verteilung der Messpunkte, an denen die Topografie gemessen wird, ist an die jeweilige Messaufgabe angepasst. Bei dem in der Figur 1 dargestellten Ausführungsbeispiel ist angenommen, dass die Messpunkte entlang zweier Linien 11, 13 angeordnet sind, die senkrecht zueinander angeordnet sind, sich in der Mitte des Wafers 10 kreuzen und sich jeweils bis zum umlaufenden Rand des Wafers 10 hin erstrecken. Andere Messmuster, z.B. Spiralen oder Gittermuster, kommen aber selbstverständlich ebenfalls in Betracht. Die Messpunkte können sehr eng benachbart sein und z.B. einen Abstand von wenigen Mikrometern haben. Bei anderen Messmustern liegen die Abstände im Bereich von 1 mm.

### 2. Aufbau und Funktion der Messvorrichtung

Die Figur 2 zeigt eine erfindungsgemäße und insgesamt mit 14 bezeichnete Messvorrichtung in einer schematischen Darstellung. Die Messvorrichtung 14 dient dazu, einen Wafer 10 zu vermessen, der hier von einer Halterung 18 getragen wird. Die Halterung 18 kann zum Beispiel als einfache Dreipunktlagerung ausgebildet sein, wie dies in der Figur 2 durch Abstützungen 20 angedeutet ist. Im dargestellten Ausführungsbeispiel stützt sich die Halterung 18 ihrerseits auf einer Basis 16 ab. In der Regel sind die Halterung 18 und die Basis 16 nicht Teil der Messvorrichtung 14. Bei einer Messung innerhalb des Produktionsablaufs kann der Wafer 10 der Messvorrichtung 14 z.B. auch von einer Fördereinrichtung zugeführt werden.

Die Messvorrichtung 14 umfasst eine optischen Kohärenztomographen 22, der einen Messlichtstrahl 24 erzeugt und dessen Aufbau weiter unten näher erläutert wird.

Eine insgesamt mit 26 angedeutete Scaneinrichtung 26 lenkt den Messlichtstrahl 24 variabel in zwei Raumlichtungen ab. Zu diesem Zweck weist die Scaneinrichtung 26 einen ersten Scanspiegel 28 auf, der um eine erste Drehachse 30 drehbar gelagert ist. Ein zweiter Scanspiegel 32 ist um eine zweite Drehachse 34 drehbar gelagert, die senkrecht zur ersten Drehachse 30 orientiert ist. Angetrieben werden die Scanspiegel 28, 32 durch Galvanometerantriebe (nicht gezeigt), die von einer Steuereinheit 36 angesteuert werden.

Zur Messvorrichtung 14 gehört ferner ein optisches System 38, das in der Figur 2 durch drei Linsen L1, L2 und L3 angedeutet ist. Das optische System 38 fokussiert im dargestellten Ausführungsbeispiel den von der Scaneinrichtung 26 abgelenkten Messlichtstrahl 24 so, dass er stets näherungsweise senkrecht auf die zum optischen System weisende Oberfläche 40 des Wafers 10 trifft.

Der optische Kohärenztomograph 22 enthält in an sich bekannter Weise eine Lichtquelle 42, einen ersten Strahlteiler 44, der das von der Lichtquelle erzeugte Licht in den Messlichtstrahl 24 und einen Referenzlichtstrahl 46 aufteilt, einen Referenzarm 48 zur Führung des Referenzlichtstrahls 46 sowie einen das optische System 38 und die Scaneinrichtung 26 nutzenden Objektarm 50, in dem der Messlichtstrahl 24 geführt wird.

Während einer Messung wird der sich im Objektarm 50 ausbreitende Messlichtstrahl 24 auf die Oberfläche 40 des Wafers 10 fokussiert, dort teilweise reflektiert und gelangt auf dem gleichen Lichtweg über den Objektarm 50 zurück zum ersten Strahlteiler 44. Dort überlagert sich der reflektierte Anteil des Messlichtstrahls 24 mit dem im Referenzarm 48 geführten und dort an einem Spiegel 52 reflektierten Referenzlichtstrahl 46. Beide Lichtanteile werden von einem zweiten Strahlteiler 54 auf einen Detektor 56 gerichtet, der das optische Referenzsignal in ein elektrisches Signal umwandelt.

Der optische Kohärenztomograph 22 ist im dargestellten Ausführungsbeispiel als FD-OCT ausgebildet (FD steht für *Fourier Domain*)*.* Der Detektor 56 enthält deswegen ein Spektrometer, das die spektrale Intensitätsverteilung erfasst. Daraus kann eine mit dem Detektor 56 verbundene Auswerteeinheit 57 in an sich bekannter Weise den Abstand der Oberfläche 40 zur Messvorrichtung 14 (beispielsweise der Linse L3) am Auftreffpunkt des Messlichtstrahls 24 berechnen. Wegen weiterer Einzelheiten zum optischen Kohärenztomographen wird auf die eingangs bereits erwähnte DE 10 2017 128 158 A1 verwiesen.

Der Wellenlängenbereich des von der Lichtquelle 42 erzeugten Lichts kann so gewählt sein, dass der Messlichtstrahl 24 zumindest teilweise in den Wafer 10 eindringen kann. Dann entsteht an der von der Messvorrichtung 14 abgewandten unteren Oberfläche 58 des Wafers 10 ebenfalls ein Reflex, der vom optischen Kohärenztomographen 22 erfasst wird. In diesem Fall überlagern sich zwei Messlichtstrahlen 24, die unterschiedliche optische Weglängen zurückgelegt haben. Der Detektor 56 erfasst dann in an sich bekannter Weise über die Periodizität der Interferenz die Differenz der optischen Weglängen, woraus auf den Abstand zwischen den beiden Oberflächen 40, 58 des Wafers 10 und damit auf dessen Dicke zurückgeschlossen werden kann.

Wenn man den vorstehend beschriebenen Dickenmodus wählt, sollte verhindert werden, dass sich auch im Referenzarm 48 Licht ausbreiten kann, da dieses ebenfalls zu Interferenz beitragen würde und auf diese Weise unerwünschte Störsignale erzeugt. Der Referenzarm 48 enthält zu diesem Zweck eine bei 60 angedeutete schaltbare Abblendeinrichtung, die beispielsweise als Zentral- oder Schlitzverschluss ausgebildet sein kann. Beim Wechsel vom Abstandsmodus in den Dickenmodus wird automatisch die schaltbare Abblendeinrichtung 60 geschlossen, wodurch zur Interferenz auf dem Detektor 56 kein Licht aus dem Referenzarm 48 mehr beitragen kann. Wird wieder in den Abstandsmodus zurückgewechselt, gibt die schaltbare Abblendeinrichtung 60 den Weg für den Referenzlichtstrahl 46 wieder frei.

Optional verfügt der Referenzarm 48 über einen Kontrollmechanismus der Abblendeinrichtung 60, insbesondere einen Sensor, welcher den Zustand der Abblendeinrichtung 60 feststellen kann. Mit Hilfe des Kontrollmechanismus kann beispielsweise nach einer Unterbrechung der Stromzufuhr der aktuelle Zustand überprüft werden.

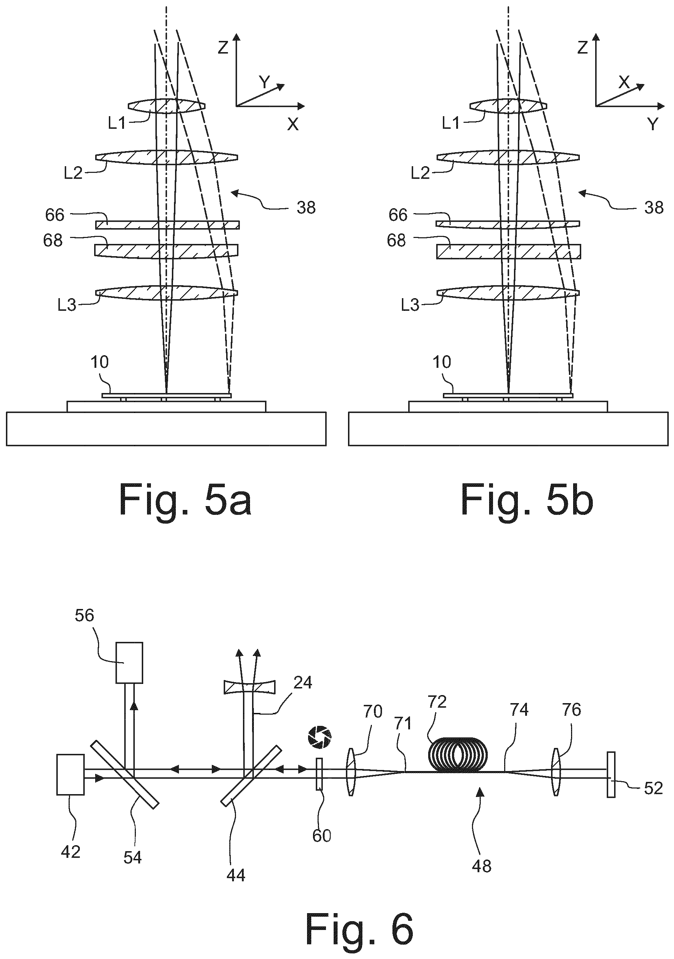

Bei dem in der Figur 2 gezeigten Ausführungsbeispiel breitet sich das Messlicht 24 vollständig im Freiraum aus. Bei anderen Ausführungsbeispielen findet die Lichtführung teilweise in optischen Fasern statt, wie dies weiter unten mit Bezug auf die Figur 6 erläutert wird. Falls der optische Kohärenztomograph 22 in einem eigenen Gehäuse untergebracht ist, bietet es sich an, das Licht zwischen dem optischen Kohärenztomographen 22 und der Scaneinrichtung 26 ebenfalls in einer optischen Faser zu führen. Die Scaneinrichtung 26 und das optische System 38 können dann in einem räumlich kompakten und leichten Messkopf untergebracht sein, der mit geringem Aufwand an unterschiedlichen Orten montiert werden kann.

### 3. Feldkrümmung

Das optische System 38 ist zwar als Planfeldoptik ausgelegt, so dass in das optische System 38 eintretendes kollimiertes Licht in eine plane Brennebene fokussiert wird. Es wurde jedoch festgestellt, dass trotzdem die Fokuspunkte des Messlichtstrahls 24 nicht exakt in einer Ebene liegen.

Diese unerwünschte Feldkrümmung ist darauf zurückzuführen, dass die beiden Scanspiegel 28, 32 räumlich hintereinander angeordnet sind, wodurch es zu anschaulich nicht leicht nachvollziehbaren Weglängenänderungen kommt. Diese Weglängenänderungen wachsen quadratisch mit zunehmenden Drehwinkeln der Scanspiegel 28, 32 und damit mit zunehmendem Abstand der Messpunkte von der optischen Achse OA des optischen Systems 38.

Üblicherweise ist die optische Weglänge im Referenzarm 48 so gewählt, dass sie mit der optischen Weglänge im Objektarm 50 bis zum Fokuspunkt des Messlichtstrahls 24 übereinstimmt. Befindet sich eine reflektierende Oberfläche außerhalb des Fokuspunktes, interpretiert der Kohärenztomograph 22 dies so, dass die betreffende Oberfläche weiter oder näher liegt als die durch den Referenzarm 48 vorgegebene optische Weglänge. Wenn die Brennpunkte des Messlichtstrahls 24 jedoch nicht exakt in einer Ebene liegen, führt dies dazu, dass eine eigentlich plane Oberfläche gekrümmt erscheint. In einem Abstand von 150 mm von der optischen Achse OA entfernt beträgt der resultierende Messfehler bereits rund 1 mm, was drei Größenordnungen mehr ist als die geforderte Messgenauigkeit von 1 µm.

Zur Lösung dieses Problems wird vor der Auslieferung der Messvorrichtung 14 eine Kalibriermessung durchgeführt. Hierzu wird ein hochgenau gefertigtes Kalibriernormal in Form einer planen Glasplatte vermessen. Die infolge der Feldkrümmung gemessenen Abweichungen von der Planarität werden in Korrekturwerte übersetzt, die in der Auswerteeinheit 57 in einer Tabelle gespeichert werden. Für jeden Messpunkt, der von der Scaneinrichtung 26 auf der Oberfläche des Kalibriernormals angefahren werden kann, wird ein Korrekturwert ermittelt, der diesem Messpunkt zugewiesen ist. Die Zuordnung von Messpunkten und Korrekturwerten können in der Auswerteeinheit 57 in einer Tabelle gespeichert sein.

Alternativ können die Korrekturwerte aus einer Formel berechnet werden, die aus der Kalibriermessung abgeleitet wird. Denkbar sind auch kombinierte Lösungen, bei denen lediglich für einzelne Stützstellen Korrekturwerte tabellarisch hinterlegt und für zwischen den Stützstellen liegende Orte die Korrekturwerte durch Interpolation gewonnen werden.

Wenn nach einer solchen Kalibrierung reale Wafer 10 vermessen werden, werden die entsprechenden Korrekturwerte je nach Vorzeichen von den erhaltenen Messwerten addiert oder subtrahiert. Dadurch erhält man einen korrigierten Satz von Messwerten, der zum Zwecke der Weiterverarbeitung an den Benutzer der Messvorrichtung 14 ausgegeben werden kann.

### 4. Maßnahmen zur Verringerung der Feldkrümmung

Alternativ oder zusätzlich zur Kalibrierung können Maßnahmen ergriffen werden, um die Feldkrümmung möglichst weitgehend zu verringern.

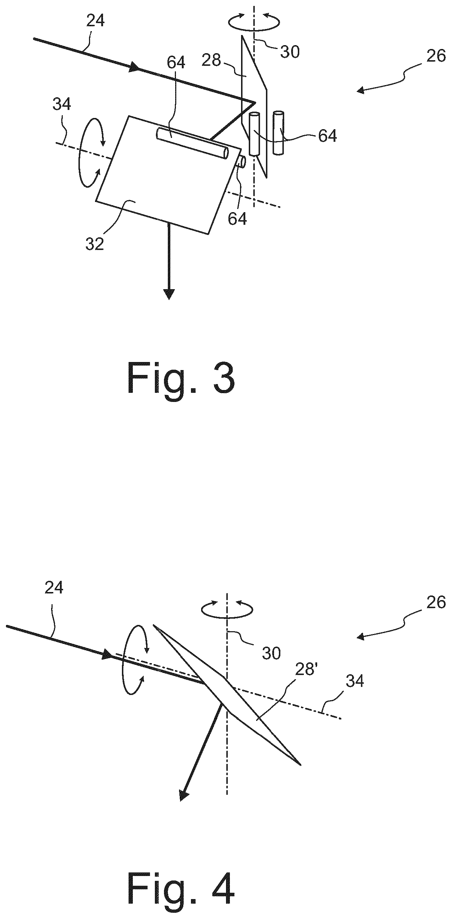

Eine solche Maßnahme kann z.B. darin bestehen, den Abstand zwischen den beiden Scanspiegeln 28, 32 zu verringern. Normalerweise ist dieser Abstand so gewählt, dass die Scanspiegel 28, 32 auch bei größeren Drehwinkeln unter keinen Umständen kollidieren können. Für die vorstehend beschriebenen Vermessung von Wafer 10 werden in der Regel jedoch nur relativ kleine Drehwinkel in der Größenordnung ± 10° oder sogar nur ± 5° benötigt. Die kleineren Drehwinkel ermöglichen es, die beiden Scanspiegel 28, 32 näher zueinander anzuordnen. Da die Scanspiegel 28, 32 grundsätzlich aber über einen größeren Drehwinkelbereich verfügen, muss eine Kollisionsschutzeinrichtung vorgesehen sein, um zuverlässig zu verhindern, dass die Scanspiegel 28, 32 sich beim Betrieb berühren. Bei dem in der Figur 3 dargestellten Ausführungsbeispiel weist die Kollisionsschutzeinrichtung mechanische Anschläge 64 auf, die zum Beispiel durch Gummilippen gebildet sein können. Die mechanischen Anschläge 64 sind so positioniert, dass sie die konstruktiv an sich möglichen Drehwinkel der Scanspiegel 28, 32 auf die erforderlichen Drehwinkel begrenzen.

Abhängig vom Abstand und von der Größe der Scanspiegel kann es ausreichend sein, nur einen der beiden Scanspiegel 28, 32 mit einer Kollisionsschutzeinrichtung zu versehen.

Noch geringer wird die Feldkrümmung, wenn die Scaneinrichtung 26 nicht zwei Scanspiegel 28, 32 aufweist, die jeweils um eine einzige Drehachse 30 bzw. 34 drehbar gelagert sind, sondern nur einen einzigen Scanspiegel 28', der um zwei vorzugsweise orthogonale Drehachsen 30, 34 gelagert ist, wie dies die Figur 4 in einer perspektivischen schematischen Darstellung illustriert.

Die Figuren 5a und 5b zeigen das optische System 38 der Messvorrichtung 14 gemäß einem alternativen Ausführungsbeispiel in zwei orthogonalen meridionalen Schnitten, nämlich in der XZ-Ebene in der Figur 5a und in der YZ-Ebene in der Figur 5b. Bei dieser Messvorrichtung 14 sind ebenfalls zwei Scanspiegel vorgesehen. Die Feldkrümmung wird hier durch ein geeignet ausgelegtes System 38 verringert. Hierzu weist das optische System 38 eine erste Zylinderlinse 66 und eine zweite Zylinderlinse 68 auf, wobei die Symmetrieachsen der Zylinderlinsen 66, 68 senkrecht zueinander verlaufen, wie dies in den Figuren 5a, 5b erkennbar ist. Die beiden Zylinderlinsen 66, 68 sind jeweils einem der beiden Scanspiegel 28, 32 zugeordnet. Die Orientierung der Symmetriachsen der Zylinderlinsen 66, 68 ist deswegen auf die Orientierung der Drehachsen 30, 34 der Scanspiegel 28 bzw. 32 abgestimmt.

Die Figur 6 zeigt einen Ausschnitt aus dem optischen Kohärenztomographen 22. Damit der Messlichtstrahl 24 auch große Wafer 10 bis zu dessen Rand hin abtasten kann, muss das optische System 38 eine große Brennweite haben, was zu einer großen geometrischen und optischen Weglänge im Objektarm 50 führt. Entsprechend lang muss auch die optische Weglänge im Referenzarm 48 sein.

Da eine Freistrahlausbreitung über lange Strecken hinweg komplizierte Strahlfaltungen erfordert, kann es günstiger sein, wenn im Referenzarm 48 der Messlichtstrahl 24 nicht oder jedenfalls nicht durchweg als Freistrahl geführt wird, sondern zumindest teilweise in einer optischen Faser. In der Figur 6 koppelt eine im Lichtweg hinter der Abblendeinrichtung 60 angeordnete Einkoppellinse 70 den Messlichtstrahl in ein Ende 71 einer aufgerollten optischen Faser 72 ein. Zwischen dem Ende 74 der optischen Faser 72 und dem Spiegel 52 ist eine zweite Koppellinse 76 angeordnet, um den am Spiegel 52 reflektierten Referenzlichtstrahl wieder in die Faser 72 einzukoppeln.

Die Aufspaltung des Referenzarms 48 in einen fasergeführten und einen freistrahlgeführten Teil ist dabei nicht auf das in Fig. 6 gezeigte Ausführungsbeispiel begrenzt. Insbesondere kann der Strahlteiler 44 in einer alternativen Ausführung auch als Faserkoppler realisiert sein.

## Patentansprüche

1. Vorrichtung (14) zum Vermessen von Wafern (10), mit
einem optischen Kohärenztomographen (22), der dazu eingerichtet ist, einen Messlichtstrahl (24) zu erzeugen und über ein optisches System (38) auf den Wafer (10) zu richten,
einer Scaneinrichtung (26), die dazu eingerichtet ist, den Messlichtstrahl (24) in zwei Raumrichtungen abzulenken,
einer Steuereinheit (36), die dazu eingerichtet ist, die Scaneinrichtung (26) so zu steuern, dass der Messlichtstrahl (24) die zum optischen System (38) weisende Oberfläche (40) des Wafers (10) nacheinander an mehreren Messpunkten abtastet, wobei zwei Messpunkte einen Abstand dₘₐₓ mit 140 mm ≤ dₘₐₓ≤ 600 mm haben, und mit
einer Auswerteeinheit (57), die dazu eingerichtet ist, aus von dem optischen Kohärenztomographen (22) bereitgestellten Interferenzsignalen Abstandswerte und/ oder Dickenwerte zu berechnen,
**dadurch gekennzeichnet, dass**
das optische System (38) als Planfeldoptik ausgelegt ist, die dazu eingerichtet ist, den von der Scaneinrichtung (26) abgelenkten Messlichtstrahl (24) so zu fokussieren, dass er stets näherungsweise senkrecht auf die zum optischen System (38) weisende Oberfläche (40) des Wafers (10) trifft.

2. Vorrichtung nach Anspruch 1, **dadurch gekennzeichnet, dass** der optische Kohärenztomograph (22) aufweist:
eine Lichtquelle (42),
einen Strahlteiler (44), der dazu eingerichtet ist, von der Lichtquelle erzeugtes Licht in den Messlichtstrahl (24) und einen Referenzlichtstrahl (46) aufzuteilen, einen Referenzarm (48) zur Führung des Referenzlichtstrahls (46),
einen das optische System (38) und die Scaneinrichtung (26) nutzenden Objektarm (50) zur Führung des Messlichtstrahls (24),
einen Detektor (56), der dazu eingerichtet ist, aus einer Überlagerung des im Referenzarm (48) geführten Referenzlichtstrahls (46) mit einem an dem Wafer (10) reflektierten Anteil des Messlichtstrahls (24) die Interferenzsignale zu erzeugen.

3. Vorrichtung nach Anspruch 2, **dadurch gekennzeichnet, dass** im Referenzarm (48) eine schaltbare Abblendeinrichtung (60) angeordnet ist, die dazu eingerichtet ist, bei der Vornahme von Dickenmessungen die Ausbreitung des Referenzlichtstrahls (46) im Referenzarm (48) zu unterbinden.

4. Vorrichtung nach einem der vorhergehenden Ansprüche, **dadurch gekennzeichnet, dass** das optische System (38) ein Feld hat, in das die Messlichtstrahlen (24) fokussiert werden, und dass die Auswerteeinheit (57) dazu eingerichtet ist, die gemessenen Abstandswerte rechnerisch zu korrigieren, um eine Krümmung des Feldes zu kompensieren.

5. Vorrichtung nach Anspruch 4, **dadurch gekennzeichnet, dass** zur rechnerischen Korrektur Korrekturwerte aus einer in der Auswerteeinheit (57) gespeicherten Korrekturtabelle auslesbar sind.

6. Vorrichtung nach Anspruch 5, **dadurch gekennzeichnet, dass** in der Korrekturtabelle Korrekturwerte für unterschiedliche Betriebswellenlängenbereiche gespeichert sind.

7. Vorrichtung nach einem der vorhergehenden Ansprüche, **dadurch gekennzeichnet, dass** die Scaneinrichtung (26) genau zwei Scanspiegel (28, 32) hat, die jeweils um genau eine Achse (30, 34) drehbar gelagert sind, und dass mindestens einem der zwei Scanspiegel (28, 32) eine Kollisionsschutzeinrichtung (64) zugeordnet ist, die dazu eingerichtet ist, Drehwinkel des mindestens einen Scanspiegels (28, 32) zu begrenzen.

8. Vorrichtung nach Anspruch 7, **dadurch gekennzeichnet, dass** die Kollisionseinrichtung mindestens einen mechanischen Anschlag (64) aufweist.

9. Vorrichtung nach Anspruch 7 oder 8, **dadurch gekennzeichnet, dass** die Kollisionseinrichtung eine elektronische Begrenzungseinrichtung aufweist, die dazu eingerichtet ist, elektronisch eine Zufuhr von Steuersignalen an den mindestens einen Scanspiegel (28, 32) zu verhindern, die zu einem Überschreiten eines vorgegebenen Drehwinkelbereichs führen würde.

10. Vorrichtung nach einem der vorhergehenden Ansprüche, **dadurch gekennzeichnet, dass** das optische System zur Korrektur einer Feldkrümmung mindestens ein anamorphotisches optisches Element (66, 68) enthält.

11. Vorrichtung nach einem der Ansprüche 1 bis 6, **dadurch gekennzeichnet, dass** die Scaneinrichtung (26) genau einen Scanspiegel (28') hat, der um zwei Achsen (30, 34) drehbar gelagert ist.

12. Verfahren zum Vermessen von Wafern (10), mit folgenden Schritten:
a) Erzeugen eines Messlichtstrahls (24) mit einem optischen Kohärenztomographen (22);
b) Richten des Messlichtstrahls (24) auf den Wafer (10) mit einem optischen System (38);
c) Ablenken des Messlichtstrahl (24) in zwei Raumrichtungen mit einer Scaneinrichtung (26), die so gesteuert wird, dass der Messstrahl die Oberfläche (40) des Wafers (10) nacheinander an mehreren Messpunkten abtastet;
d) Berechnen von Abstandswerten und/oder Dickenwerten auf der Grundlage von Interferenzsignalen, die von dem optischen Kohärenztomographen (22) bereitgestellt werden,
**dadurch gekennzeichnet, dass**
zwei Messpunkte einen Abstand dₘₐₓ mit 140 mm ≤ dₘₐₓ≤ 600 mm haben,
das optische System (38) als Planfeldoptik ausgelegt ist, und dass
in Schritt c) das optische System (38) den von der Scaneinrichtung (26) abgelenkten Messlichtstrahl (24) so fokussiert, dass er stets näherungsweise senkrecht auf die zum optischen System (38) weisende Oberfläche (40) des Wafers (10) trifft.

13. Verfahren nach Anspruch 12, **dadurch gekennzeichnet, dass** in dem optischen Kohärenztomographen (22)
eine Lichtquelle (42) Licht erzeugt;
ein Strahlteiler (44) das von der Lichtquelle (42) erzeugtes Licht in den Messlichtstrahl (24) und einen Referenzlichtstrahl (46) aufteilt;
der Referenzlichtstrahl (46) in einem Referenzarm (48) geführt wird;
der Messlichtstrahl (24) in einem Objektarm (50) geführt wird;
ein Detektor (56) aus einer Überlagerung des im Referenzarm (48) geführten Referenzlichtstrahls (46) mit einem Anteil des Messlichtstrahls (46), der von dem Wafer (10) reflektiert wird, die Interferenzsignale erzeugt.

## Claims

1. Device (14) for measuring wafers (10), comprising
an optical coherence tomograph (22) configured to generate a measuring light beam (24) and to direct it onto the wafer (10) via an optical system (38),
a scanning device (26) configured to deflect the measuring light beam (24) in two spatial directions,
a control unit (36) configured to control the scanning device (26) in such a way that the measuring light beam (24) scans the surface (40) of the wafer (10) facing the optical system (38) successively at a plurality of measuring points, wherein two measuring points have a distance dₘₐₓ of 140 mm ≤ dₘₐₓ ≤ 600 mm, and
an evaluation unit (57) configured to calculate distance values and/or thickness values from interference signals provided by the optical coherence tomograph (22),
**characterized in that**
the optical system (38) is designed as a plane-field optical system configured to focus the measuring light beam (24) deflected by the scanning device (26) in such a way that it always strikes the surface (40) of the wafer (10) facing the optical system (38) approximately perpendicularly.

2. Device according to claim 1, **characterized in that** the optical coherence tomograph (22) comprises:
a light source (42),
a beam splitter (44) configured to split light generated by the light source into the measuring light beam (24) and a reference light beam (46),
a reference arm (48) for guiding the reference light beam (46),
an object arm (50) utilizing the optical system (38) and the scanning device (26) for guiding the measuring light beam (24),
a detector (56) configured to generate the interference signals from a superposition of the reference light beam (46) guided in the reference arm (48) with a portion of the measuring light beam (24) reflected at the wafer (10).

3. Device according to claim 2, **characterized in that** a switchable dimming device (60) is arranged in the reference arm (48), which is configured to prevent the propagation of the reference light beam (46) in the reference arm (48) when thickness measurements are made.

4. Device according to any of the preceding claims, **characterized in that** the optical system (38) has a field into which the measuring light beams (24) are focused, and **in that** the evaluation unit (57) is configured to correct the measured distance values by calculation in order to compensate for a curvature of the field.

5. Device according to claim 4, **characterized in that** correction values can be read out from a correction table stored in the evaluation unit (57) for the purpose of computational correction.

6. Device according to claim 5, **characterized in that** correction values for different operating wavelengths ranges are stored in the correction table.

7. Device according to any of the preceding claims, **characterized in that** the scanning device (26) has exactly two scanning mirrors (28, 32) which are each mounted rotatably about exactly one axis (30, 34), and **in that** at least one of the two scanning mirrors (28, 32) is associated with a collision protection device (64) which is configured to limit angles of rotation of the at least one scanning mirror (28, 32).

8. Device according to claim 7, **characterized in that** the collision device has at least one mechanical stop (64).

9. Device according to claim 7 or 8, **characterized in that** the collision device has an electronic limiting device which is configured to electronically prevent a supply of control signals to the at least one scanning mirror (28, 32) which would lead to a predetermined angle of rotation range being exceeded.

10. Device according to one of the preceding claims, **characterized in that** the optical system comprises at least one anamorphic optical element (66, 68) for correcting a field curvature.

11. Device according to one of claims 1 to 6, **characterized in that** the scanning device (26) has exactly one scanning mirror (28') which is mounted rotatably about two axes (30, 34).

12. Method for measuring wafers (10), comprising the following steps:
a) generating a measuring light beam (24) with an optical coherence tomograph (22);
b) directing the measuring light beam (24) at the wafer (10) with an optical system (38);
c) deflecting the measuring light beam (24) in two spatial directions with a scanning device (26), which is controlled in such a way that the measuring beam scans the surface (40) of the wafer (10) successively at a plurality of measuring points;
d) calculating distance values and/or thickness values based on interference signals provided by the optical coherence tomograph (22).
**characterized in that**
two measuring points have a distance dₘₐₓ of 140 mm ≤ dₘₐₓ ≤ 600 mm,
the optical system (38) is designed as a plane-field optical system, and **in that**
in step c) the optical system (38) focuses the measuring light beam (24) deflected by the scanning device (26) in such a way that it always strikes the surface (40) of the wafer (10) facing the optical system (38) approximately perpendicularly.

13. Method according to claim 12, **characterized in that** in the optical coherence tomograph (22)
a light source (42) generates light;
a beam splitter (44) splits the light generated by the light source (42) into the measuring light beam (24) and a reference light beam (46);
the reference light beam (46) is guided in a reference arm (48);
the measuring light beam (24) is guided in an object arm (50);
a detector (56) generates the interference signals from a superposition of the reference light beam (46) guided in the reference arm (48) with a portion of the measurement light beam (46) which is reflected by the wafer (10).

## Revendications

1. Dispositif (14) de mesure de tranches (10), avec
un tomographe à cohérence optique (22) qui est configuré pour générer un rayon lumineux de mesure (24) et le diriger vers la tranche (10) par le biais d'un système optique (38),
une installation de balayage (26) qui est configurée pour dévier le rayon lumineux de mesure (24) dans deux directions spatiales,
un module de commande (36) qui est configuré pour commander l'installation de balayage (26) de sorte que le rayon lumineux de mesure (24) balaie la surface (40) de la tranche (10) tournée vers le système optique (38) en plusieurs points de mesure successivement, dans lequel deux points de mesure ont un écart dₘₐₓ avec 140 mm ≤ dₘₐₓ ≤ 600 mm, et avec
un module d'évaluation (57) qui est configuré pour calculer à partir de signaux d'interférence mis à disposition par le tomographe à cohérence optique (22) des valeurs d'écart et/ou valeur d'épaisseur,
**caractérisé en ce que**
le système optique (38) est conçu en tant qu'optique à champ plat qui est configurée pour concentrer le rayon lumineux de mesure (24) dévié par l'installation de balayage (26) de sorte qu'il est incident de manière toujours approximativement perpendiculaire sur la surface (40) de la tranche (10) tournée vers le système optique (38).

2. Dispositif selon la revendication 1, **caractérisé en ce que** le tomographe à cohérence optique (22) présente :
une source lumineuse (42),
un séparateur de faisceaux (44) qui est configuré pour diviser de la lumière générée par la source lumineuse en le rayon lumineux de mesure (24) et un rayon lumineux de référence (46),
un bras de référence (48) pour le guidage du rayon lumineux de référence (46),
un bras d'objet (50) utilisant le système optique (38) et l'installation de balayage (26) pour le guidage du rayon lumineux de mesure (24),
un détecteur (56) qui est configuré pour générer les signaux d'interférence à partir d'une superposition du rayon lumineux de référence (46) guidé dans le bras de référence (48) avec une proportion du rayon lumineux de mesure (24) réfléchie sur la tranche (10).

3. Dispositif selon la revendication 2, **caractérisé en ce qu'**une installation de réglage de diaphragme commutable (60) est disposée dans le bras de référence (48), laquelle est configurée pour supprimer la propagation du rayon lumineux de référence (46) dans le bras de référence (48) lors de la réalisation de mesures d'épaisseur.

4. Dispositif selon une des revendications précédentes, **caractérisé en ce que** le système optique (48) a un champ dans lequel les rayons lumineux de mesure (24) sont concentrés, et que le module d'évaluation (57) est configuré pour corriger par calcul les valeurs d'écart mesurées pour compenser une courbure du champ.

5. Dispositif selon la revendication 4, **caractérisé en ce que** des valeurs de correction peuvent être lues à partir d'un tableau de correction mémorisé dans le module d'évaluation (57) pour la correction par calcul.

6. Dispositif selon la revendication 5, **caractérisé en ce que** des valeurs de correction sont mémorisées dans le tableau de correction pour différentes plages de longueur d'onde de service.

7. Dispositif selon une des revendications précédentes, **caractérisé en ce que** l'installation de balayage (26) a exactement deux miroirs de balayage (28, 32) qui sont chacun logés de manière rotative autour d'exactement un axe (30, 34), et qu'une installation de protection contre la collision (64) est associée à au moins un des deux miroirs de balayage (28, 32), laquelle est configurée pour limiter des angles de rotation de l'au moins un miroir de balayage (28, 32).

8. Dispositif selon la revendication 7, **caractérisé en ce que** l'installation de collision présente au moins une butée mécanique (64).

9. Dispositif selon la revendication 7 ou 8, **caractérisé en ce que** l'installation de collision présente une installation de limitation électronique qui est configurée pour empêcher électroniquement un acheminement de signaux de commande à l'au moins un miroir de balayage (28, 32) qui conduirait à un dépassement d'une plage d'angle de rotation prédéfinie.

10. Dispositif selon une des revendications précédentes, **caractérisé en ce que** le système optique pour la correction d'une courbure de champ contient au moins un élément optique anamorphoseur (66, 68).

11. Dispositif selon une des revendications 1 à 6, **caractérisé en ce que** l'installation de balayage (26) a exactement un miroir de balayage (28') qui est logé à rotation autour de deux axes (30, 34).

12. Procédé de mesure de tranches (10), avec les étapes suivantes :
a) génération d'un rayon lumineux de mesure (24) avec un tomographe à cohérence optique (22) ;
b) direction du rayon lumineux de mesure (24) vers la tranche (10) avec un système optique (38) ;
c) déviation du rayon lumineux de mesure (24) dans deux directions spatiales avec une installation de balayage (26) qui est commandée de sorte que le rayon de mesure balaie la surface (40) de la tranche (10) en plusieurs points de mesure successivement ;
d) calcul de valeurs d'écart et/ou valeurs d'épaisseur sur la base de signaux d'interférence qui sont mis à disposition par le tomographe à cohérence optique (22),
**caractérisé en ce que**
deux points de mesure ont un écart dₘₐₓ avec 140 mm ≤ dₘₐₓ ≤ 600 mm,
le système optique (38) est conçu en tant qu'optique à champ plat, et que
à l'étape c) le système optique (38) concentre le rayon lumineux de mesure (24) dévié par l'installation de balayage (26) de sorte qu'il est incident de manière toujours approximativement perpendiculaire sur la surface (40) de la tranche (10) tournée vers le système optique (38).

13. Procédé selon la revendication 12, **caractérisé en ce que** dans le tomographe à cohérence optique (22)
une source lumineuse (42) génère de la lumière ;
un séparateur de faisceaux (44) qui divise de la lumière générée par la source lumineuse (42) en le rayon lumineux de mesure (24) et un rayon lumineux de référence (46) ;
le rayon lumineux de référence (46) est guidé dans un bras de référence (48) ;
le rayon lumineux de mesure (24) est guidé dans un bras d'objet (50) ;
un détecteur (56) génère les signaux d'interférence à partir d'une superposition du rayon lumineux de référence (46) guidé dans le bras de référence (48) avec une proportion du rayon lumineux de mesure (24) qui est réfléchie par la tranche (10).
